# EUROPEAN PATENT APPLICATION

(11) **EP 4 586 044 A1**
(43) Date of publication of application: **16.07.2025**
(21) Application number: 24218317.6
(22) Date of filing: 09.12.2024
(51) Int. Cl.: G05D 7/06, C23C 16/00, H01L 21/00

(54) **CONTROL SYSTEM, PROCESSING APPARATUS, AND METHOD OF MANUFACTURING SEMICONDUCTOR DEVICE**

(30) Priority: 11.01.2024 JP 2024002533
(71) Applicant: Kokusai Electric Corporation, Tokyo 101-0045 (JP)
(72) Inventor: NAKATANI, Shunsuke, Toyama-shi, Toyama 939-2393 (JP)
(74) Representative: Bardehle Pagenberg Partnerschaft mbB Patentanwälte Rechtsanwälte

(57) **Abstract**

There is provided a technique that includes a flow-rate controller (100) including a regulator (103) configured to be capable of regulating a flow rate of a gas; and a controller (41) configured to be capable of switching between a first mode of the flow-rate controller (100) in which the flow rate of the gas is regulated to a predetermined flow rate through operation of the regulator (103), and a second mode of the flow-rate controller (100) in which the regulator (103) is set to be in a full open state.

## Description

### CROSS-REFERENCE TO RELATED APPLICATION

This application is based upon and claims the benefit of priority from Japanese Patent Application No. 2024-002533, filed on January 11, 2024, the entire contents of which are incorporated herein by reference.

### TECHNICAL FIELD

The present disclosure relates to a control system, a processing apparatus, and a method of manufacturing a semiconductor device.

### BACKGROUND

As a process of manufacturing a semiconductor device, a process of processing a substrate may be performed in which process gases (such as a precursor gas and a reactant gas, etc.) with a controlled flow rate are supplied to a substrate to form a film on the substrate. In such a manufacturing process, since it is required to appropriately set a flow rate and pressure of a fluid, a mass flow controller (flow-rate controller) for controlling the flow rate of the fluid is installed. However, in a supply of a solid precursor (precursor with a low vapor pressure) used in recent years, there are cases where a lifespan of the flow-rate controller is shortened.

### SUMMARY

Some embodiments of the present disclosure provide a technique capable of extending a lifespan of a flow-rate controller.

According to embodiments of the present disclosure, there is provided a technique that includes a flow-rate controller including a regulator configured to be capable of regulating a flow rate of a gas; and a controller configured to be capable of switching between a first mode of the flow-rate controller in which the flow rate of the gas is regulated to a predetermined flow rate through operation of the regulator, and a second mode of the flow-rate controller in which the regulator is set to be in a full open state.

### BRIEF DESCRIPTION OF DRAWINGS

The accompanying drawings, which are incorporated in and constitute a part of the specification, illustrate embodiments of the present disclosure.
FIG. 1 is a vertical cross-sectional view illustrating a schematic configuration of a substrate processing apparatus according to the embodiments of the present disclosure.

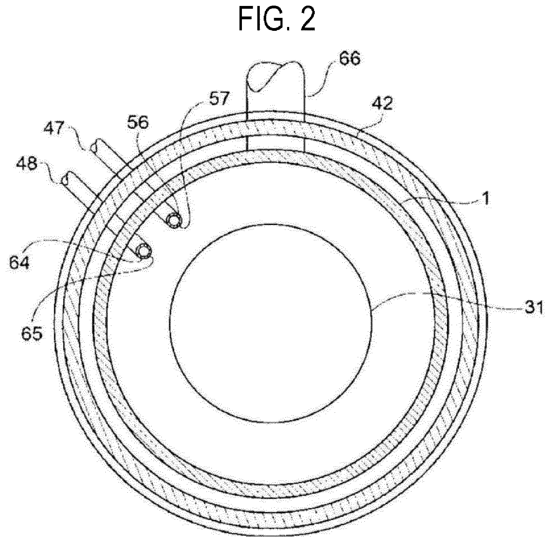

FIG. 2 is a schematic horizontal cross-sectional view taken along line A-A of FIG. 1.
FIG. 3 is a configuration diagram illustrating details of a configuration of a mass flow controller in the substrate processing apparatus according to the embodiments of the present disclosure.
FIG. 4 is a schematic diagram illustrating an operation of the mass flow controller in the substrate processing apparatus according to the embodiments of the present disclosure.
FIG. 5 is a functional block diagram illustrating a controller configuration of the substrate processing apparatus according to the embodiments of the present disclosure.
FIG. 6 is a flowchart illustrating a substrate-processing process by the substrate processing apparatus according to the embodiments of the present disclosure.
FIG. 7 is a timing chart illustrating operations of the mass flow controller and valves AV1, AV2 and AV3 in the substrate processing apparatus according to the embodiments of the present disclosure.
FIG. 8 illustrates an example of an input screen of the substrate processing apparatus according to the embodiments of the present disclosure.
FIG. 9 is a flowchart illustrating an example of an operation of the substrate processing apparatus according to the embodiments of the present disclosure.
FIG. 10 is a flowchart illustrating an example of an operation of the substrate processing apparatus according to the embodiments of the present disclosure.
FIG. 11 is a flowchart illustrating an example of an operation of the substrate processing apparatus according to the embodiment of the present disclosure.

### DETAILED DESCRIPTION

Reference are now made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to obscure aspects of the various embodiments.

Hereinafter, the present embodiments are described with reference to the accompanying drawings. The accompanying drawings illustrate embodiments according to the principles of the present disclosure, but are provided for the understanding of the present disclosure and are not to be interpreted as limiting the present disclosure in any way. The descriptions herein are merely typical examples and are not intended to limit the scope or application examples of the claims of the present disclosure in any manner.

Although the present embodiments are described in sufficient detail to enable those skilled in the art to implement the present disclosure, it should be understood that other implementations and forms are possible, and that modifications to the configurations and structures or substitutions of various elements may be made without departing from the scope and spirit of the technical idea of the present disclosure. Therefore, the following descriptions should not be interpreted in a restrictive manner.

### <Structure of Substrate Processing Apparatus>

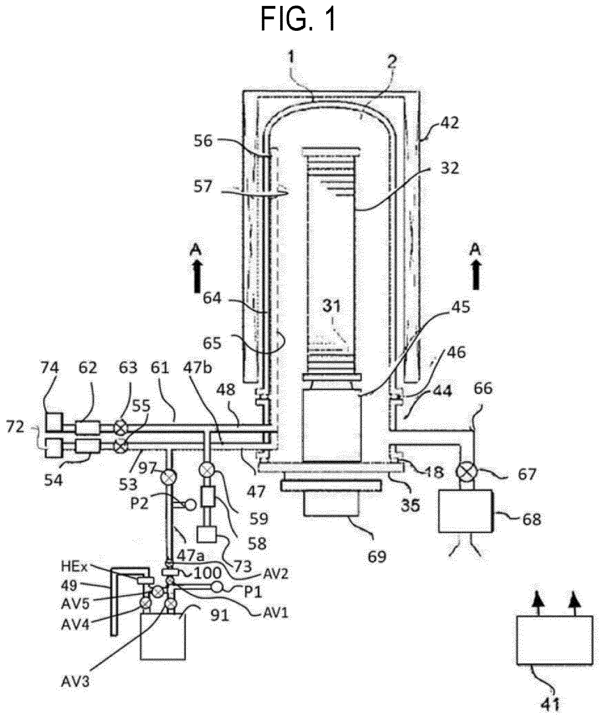

First, an outline of a substrate processing apparatus to which the present disclosure is applied is described with reference to FIG. 1. In addition, the drawings used in the following description are schematic, and dimensional relationships between respective elements, proportions of the respective elements, etc. illustrated in the drawings may not correspond to the reality. Further, the dimensional relationships between the respective elements and the proportions of the respective elements may not match among multiple drawings.

The substrate processing apparatus includes a reaction tube 1 and a boat 32. The boat 32, which serves as a holder, is charged with a predetermined number of substrates 31 serving as processing targets. Once the boat 32 is charged with the substrates 31, the boat 32 is raised by a boat elevator (not illustrated). Then, the boat 32 is loaded to an interior of the reaction tube 1.

Further, this substrate processing apparatus includes a seal cap 35 serving as a lid, O-rings 18 and 46 serving as seals, and a manifold 44, which are intended to hermetically seal a bottom of the reaction tube 1. In a state where the boat 32 is loaded to the interior of the reaction tube 1, a lower end opening (furnace opening) of the manifold 44 is hermetically closed by the lid 35 via the O-ring 18. A process container is composed of at least the reaction tube 1, manifold 44, and lid 35, and a process chamber 2 is defined in the interior of that process container. In addition, the boat 32 is erected on the lid 35 via a boat support 45. The boat support 45 serves as a holder that holds the boat 32. Further, a boat rotator 69 is installed at the lid 35. The boat rotator 69 is configured to be capable of rotating the boat 32 in order to improve the uniformity of processing.

In the process container, according to a selected process recipe, the substrates 31 are processed while process gases are supplied into the process chamber 2 through supply pipes 47 and 48, and the atmosphere of the process chamber 2 is discharged from a gas exhaust pipe 66 by a pump 68 serving as an exhauster. The gas exhaust pipe 66 is installed with a valve 67, which serves as a pressure regulation valve. The process gases herein include, for example, a precursor gas, reactant gas, and a mixture of these gases and a carrier gas, etc. Gases that contribute to the processing of the substrates 31 may be collectively referred to as "process gases" herein. In addition to these process gases, an inert gas that does not contribute to the processing of the substrates 31 is also supplied into the process chamber 2. In addition, the gases supplied into the process chamber 2, including the process gases and the inert gas, may be collectively and simply referred to as "fluid."

A controller 41 is installed as a controller for controlling the substrate processing apparatus described above. Further, the reaction tube 1 is provided inside a heater 42 serving as a heating device (heating means), and thus the reaction tube 1 is heated by heat from the heater 42. A control system that controls a flow rate of a fluid, etc., is composed of a fluid controller, including an MFC 100, and the controller 41.

The supply pipes, i.e., first and second gas supply pipes 47 and 48, illustrated in FIG. 1 are described. In the example of FIG. 1, two gas supply pipes (first gas supply pipe 47 and second gas supply pipe 48) are provided as supply paths for supplying multiple types (two types, herein) of the process gases.

First, the first gas supply pipe 47 is described. The first gas supply pipe 47 is installed, in order from an upstream, with a precursor container 91, valve AV3 (also referred to as an on-off valve or shutoff), pressure sensor P1, first mass flow controller 100 serving as a flow-rate controller (hereinafter, also referred to as MFC 100), pressure sensor P2, and valve 97. Further, a supply valve (not illustrated) is installed at a pipe that is at an upstream of the pressure sensor P2 and downstream of the MFC 100. The MFC 100, is a normally open type MFC in which the valve remains open when no voltage is applied, as described later. Further, valves AV1 and AV2 are installed, respectively, at an input side (primary side) and output side (secondary side) of the MFC 100.

The pressure sensor P2, which serves as a vacuum gauge, is located at a downstream of the MFC 100 and measures an internal pressure of the first gas supply pipe 47 during the supply of a precursor. On the other hand, the pressure sensor P1 measures a primary side pressure of the MFC 100 and is capable of measuring a wide range of pressures from 10 Torr to 1,000 Torr, for example. Although one of each of the pressure sensors P1 and P2 is illustrated in FIG. 1, each pressure sensor may be provided in a plural number.

Further, a pipe at a downstream of the valve 97 merges with a first carrier gas supply pipe 53 that supplies an inert gas. The first carrier gas supply pipe 53 is installed, in order from an upstream, with a carrier gas supplier 72, MFC 54 serving as a flow-rate controller (flow-rate control means), and valve 55 serving as an on-off valve. Further, a tip end (downstream) of the first gas supply pipe 47 is connected to a first nozzle 56. The first nozzle 56 is disposed along an inner wall of the reaction tube 1 to extend from a bottom to a top thereof. Further, first gas supply holes 57 for supplying a fluid are formed at a side surface of the first nozzle 56. These first gas supply holes 57 are formed at equal pitches from a bottom to a top of the reaction tube 1, and each possesses a same opening area. In addition, a regulator (automatic pressure control valve) may be installed instead of the MFC 54.

Herein, the first gas supply pipe 47, precursor container 91, MFC 100, pressure sensor P2, and valve 97 are collectively referred to as a first gas supplier (first gas supply line). Further, the first nozzle 56 formed within the reaction tube 1 may also be included as part of the first gas supplier. In addition to these, the first carrier gas supply pipe 53, carrier gas supplier 72, MFC 54, and valve 55 may also be included as part of the first gas supplier. Furthermore, a purge gas supply pipe 49, to be described later, may be included in the first gas supplier, and in this case, it may be referred to as a carrier gas supply pipe 49.

The precursor, such as liquid and solid precursors, etc., stored in the precursor container 91 undergoes a phase change into a gaseous state within the precursor container 91, becoming a precursor gas (gaseous fluid). This precursor gas is controlled by the MFC 100 to pass through a supply pipe 47a via the valve 97, to merge with the first carrier gas supply pipe 53, and to be supplied to the process chamber 2 through the first nozzle 56. In the present embodiments, when a solid precursor is supplied into the process chamber 2, the precursor container 91 is configured as a precursor tank. In other words, the precursor container 91 may serve as a precursor tank that generates the precursor gas, serving as a process gas, by sublimating the solid precursor through heating. The sublimated process gas is then supplied from the precursor container 91 serving as the precursor tank to the process chamber 2. Specifically, the solid precursor is placed within the precursor container 91, and the precursor container 91 is heated by a sub-heater serving as a heating means. Then, the heated solid precursor sublimates, and the gaseous precursor gas is supplied into the process chamber 2.

In addition, when a liquid precursor is supplied into the process chamber 2, the precursor container 91 may be configured as a vaporizer that generates the precursor gas serving as a process gas by vaporizing the supplied liquid precursor through heating. The precursor container 91 is heated by the sub-heater, so that the vaporized (gaseous) precursor gas is supplied from the precursor container 91 into the process chamber 2. Further, a mixed gas of the precursor gas and an inert gas serving as the carrier gas is also included in a process gas. In addition, although not particularly described, the precursor container 91 may be a container capable of accommodating the precursor gas existing in a gaseous state at room temperature.

The precursor container 91 is configured to be capable of being controlled to a temperature equal to or higher than a temperature at which the above-described precursor changes into a gaseous state by heating with the sub-heater. In addition to the sub-heater, additional heating elements may be installed to heat the supply pipe 47a between the MFC 100 and the valve 97, a supply pipe 47b between the valve 97 and the first nozzle 56, the MFC 100, the valve 97, and others, respectively. In addition, it is desirable that the heating elements, including the sub-heater, are controlled such that the temperature is controlled to become equal to or higher than the vaporization temperature of the above-described precursor, i.e., precursor for forming the fluid.

In addition, the purge gas supply pipe 49 is connected to the precursor container 91 and first gas supply pipe 47 and is intended to flow an inert gas such as nitrogen gas, etc., to execute a purge process that removes residual gases remaining in the precursor container 91, first gas supply pipe 47, and process chamber 2. A valve AV4 is installed at the purge gas supply pipe 49, and a valve AV5 is installed at a pipe (hereinafter referred to as a bypass pipe) that connects the purge gas supply pipe 49 to the first gas supply pipe 47 (supply pipe 47a) without intervening the precursor container 91, thus enabling control of an appropriate inflow of the nitrogen gas. With this configuration, a pipe including the MFC 100 in between the valves AV1 and AV2 may be purged, which may prevent a retention of the precursor gas.

Further, a heat exchanger HEx is installed at the purge gas supply pipe 49, allowing the nitrogen gas to be heated and supplied. By supplying the heated nitrogen gas, the residual gases may be discharged out of the process chamber 2 without causing pipe blockages due to cooling. In the purge process, the valve AV4 is closed to prevent the purge gas from flowing into the precursor container 91.

Next, the second gas supply pipe 48 is described. The second gas supply pipe 48 is installed, in order from an upstream, with a reactant gas supplier 73, MFC 58 serving as a flow-rate controller, and valve 59 serving as an on/off valve. The second gas supply pipe 48 merges with a second carrier gas supply pipe 61 for supplying a carrier gas, at a point at a downstream of the valve 59. The second carrier gas supply pipe 61 is installed, in order from an upstream, with a carrier gas supplier 74, MFC 62 serving as a flow-rate controller, and valve 63. A tip end (downstream) of the second gas supply pipe 48 is connected to a second nozzle 64. The second nozzle 64 is installed in the interior of the reaction tube 1 to extend parallel to the first nozzle 56. Second gas supply holes 65 for supplying a gas are formed at a side surface of the second nozzle 64. The second gas supply holes 65 may be formed at equal pitches from the bottom to the top and each may possess a same opening area.

Herein, the second gas supply pipe 48, MFC 58, valve 59, and second nozzle 64 are collectively referred to as a second gas supplier (second gas supply line). In addition, the second carrier gas supply pipe 61, MFC 62, and valve 63 may also be included as part of the second gas supplier. Furthermore, the reactant gas supplier 73 and carrier gas supplier 74 may also be included as part of the second gas supplier. Further, a reactant gas supplied from the reactant gas supplier 73 reaches the second carrier gas supply pipe 61 through the MFC 58 and valve 59, and is supplied into the process chamber 2 through the second nozzle 64.

The process chamber 2 is connected to the vacuum pump 68, which serves as an exhauster (exhaust means), through the gas exhaust pipe 66 that exhausts a gas, and is vacuum-exhausted. In addition, the valve 67, serving as a pressure regulation valve, is an on-off valve that may allow or stop the vacuum-exhaust of the process chamber 2 by opening or closing the valve, and may also enable pressure regulation by regulating an opening degree of the valve.

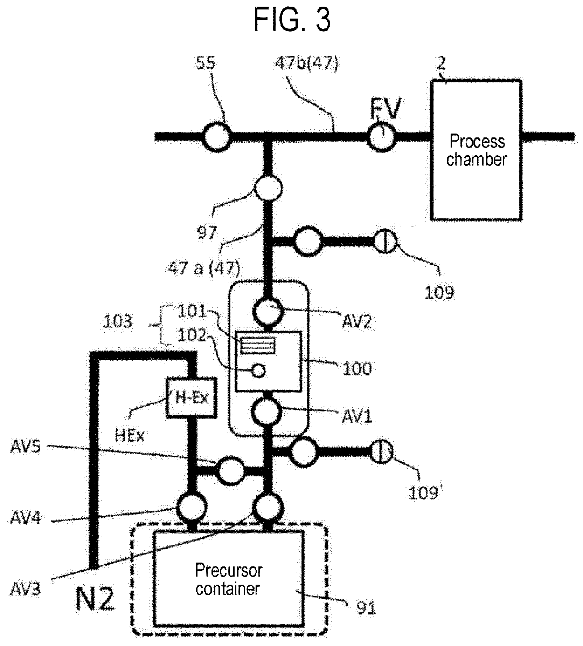

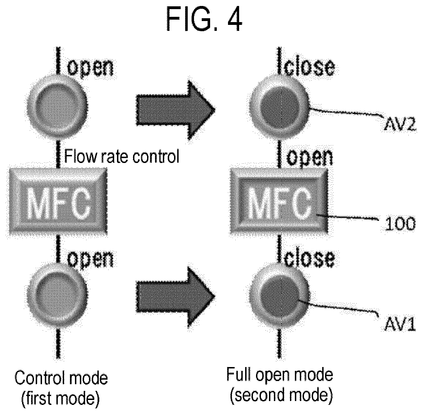

Next, details of the configuration and operation of the MFC 100 are described with reference to FIGS. 3 and 4. The MFC 100 includes a piezo actuator 101 and a valve 102 (piezo valve). The MFC 100 is capable of controlling the valve 102 by using the piezo actuator 101, thus independently regulating a flow rate of a gas (fluid) flowing through the first gas supply pipe 47. The piezo actuator 101 and valve 102 function as a regulator 103 that regulates the flow rate. Based on the operation of the regulator 103, the MFC 100 of the present embodiments is configured to be switchable between a control mode (first mode) in which the flow rate of the gas is regulated to a predetermined flow rate and a full open mode (second mode) in which the regulator 103 is in a full open state. The full open mode is an operation mode in which the control of the flow rate by the internal valve 102 of the MFC 100 is not performed but a flow path thereof is opened to a maximum extent. In the full open mode, no signal for valve control is input to the MFC 100. In other words, the full open mode is a mode in which the regulator 103 is in a non-operation state, whereas the control mode is a mode in which the regulator 103 is in an operation state. A switching operation for the regulator 103 between the first mode and the second mode is executed by the controller 41.

In addition, the MFC 100 is configured with the valves AV1 and AV2 on the input side (primary side) and output side (secondary side) thereof. The valves AV1 and AV2 are set either to a control state where an opening degree of the valve 102 is controlled or to a full open state where the valve 102 is fully opened, depending on whether the MFC 100 is set to the control mode (first mode) or the full open mode (second mode). In the present embodiments, the valves AV1 and AV2 are provided before and after the MFC 100. Due to this configuration, it is possible to shorten the time during which voltage is applied to the MFC 100, thereby extending a lifespan of the MFC 100, and a detailed operation is described later.

In general, a high-temperature type MFC poses a problem in that the piezo actuator is vulnerable to heat and thus, exhibits a shorter lifespan compared to a normal MFC. Particularly, in a normally open type MFC in which the valve remains open when no voltage is applied, even when no precursor gas is flowing, it is configured to maintain the valve at a closed state in order to keep a gas flow rate at zero. This means that voltage needs to be continuously applied to the piezo actuator. In this way, if a duration of voltage application to the piezo actuator is prolonged to maintain a zero gas flow rate, the wear of the piezo actuator accelerates, and the lifespan of the MFC is further shortened.

In consideration of these problems, as illustrated in FIG. 4, by operating the regulator 103, the MFC 100 of the present disclosure is configured to be capable of switching between the control mode (first mode) in which a flow rate of a precursor gas is regulated to a predetermined flow rate and the full open mode (second mode) in which the valve 102 is in the full open state without applying a voltage load to the regulator 103. Switching between the first mode and the full open mode (second mode) is performed in response to a command signal from the controller 41. In the full open mode, the valves AV1 and AV2 are controlled to be in a closed state (CLOSE), as described later. Conversely, in the control mode, the valves AV1 and AV2 are controlled to be in an open state (OPEN). The valves AV1 and AV2 are suitably configured to execute a same operation (i.e., be in a same state) in principle. Thus, since the valves AV1 and AV2 are in the closed stated even in the full open mode (where the valve 102 is fully opened), gas leakage from the MFC 100 may be minimized, and reverse diffusion of gases may be prevented.

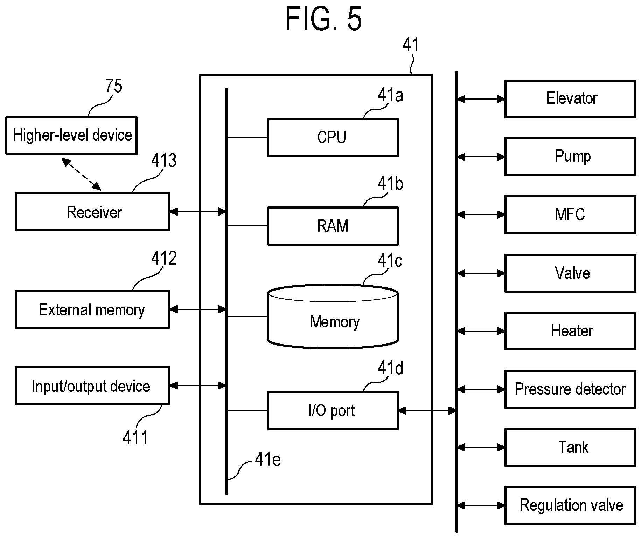

Next, the controller 41 is described with reference to the block diagram of FIG. 5. As illustrated in FIG. 5, the controller 41 is configured as a computer including a Central Processing Unit (CPU) 41a, a Random Access Memory (RAM) 41b, a memory 41c, and an I/O port 41d. The RAM 41b, memory 41c, and I/O port 41d are configured to be capable of exchanging data with the CPU 41a through an internal bus 41e. The controller 41 is configured to be connectable to an input/output device 411 composed of a touch panel, etc., and an external memory 412. Furthermore, there is provided a receiver 413 that is connected to a higher-level device 75 through a network. The receiver 413 is capable of receiving information about other devices from the higher-level device 75.

The memory 41c is composed of, for example, a flash memory, Hard Disk Drive (HDD), and others. The memory 41c stores, in a readable manner, a control program for controlling the operation of the substrate processing apparatus, a process recipe describing procedures and conditions of substrate processing as described later, and others. In addition, the process recipe is a combination that causes the controller 41 to execute each procedure of a substrate-processing process to be described later, so as to achieve predetermined results, and functions as a program. Further, the term "program" as used herein may refer to a case of solely including the process recipe, a case of solely including the control program, or a case of including both. Further, the RAM 41b is configured as a memory area (work area) where programs, data, and others read by the CPU 41a are temporarily held. Further, the I/O port 41d is connected to various components such as a lifting members, pumps, each MFC, each valve, heaters, pressure sensors (pressure detectors), tanks, regulation valves, and others.

The controller 41 controls operations of components included in the substrate processing apparatus, such as the flow rate regulation by each MFC, opening and closing of the valves, temperature regulation by the heaters, start and stop of the pumps, adjustment of the rotation speed of the boat rotator, and control of up and down movements of the boat elevator.

In addition, the controller 41 may be configured as a general computer without being limited to be configured as a dedicated computer. For example, the controller 41 of the present embodiments may be configured by preparing the external memory (e.g., semiconductor memory such as USB memory or memory card, etc.) 412 storing the aforementioned program and installing the program onto a general computer by using the external memory 412. Further, a way for supplying the program to the computer is not limited to supplying it through the external memory 412. For example, the program may be supplied by using a communication means such as the Internet or a dedicated line without using the external memory 412. In addition, the memory 41c or the external memory 412 is configured as a computer-readable recording medium. Hereinafter, these are collectively referred to simply as "recording medium." In addition, when the term "recording medium" is used herein, it may refer to a case of solely including the memory 41c, a case of solely including the external memory 412, or a case of including both.

### < Substrate Processing Method>

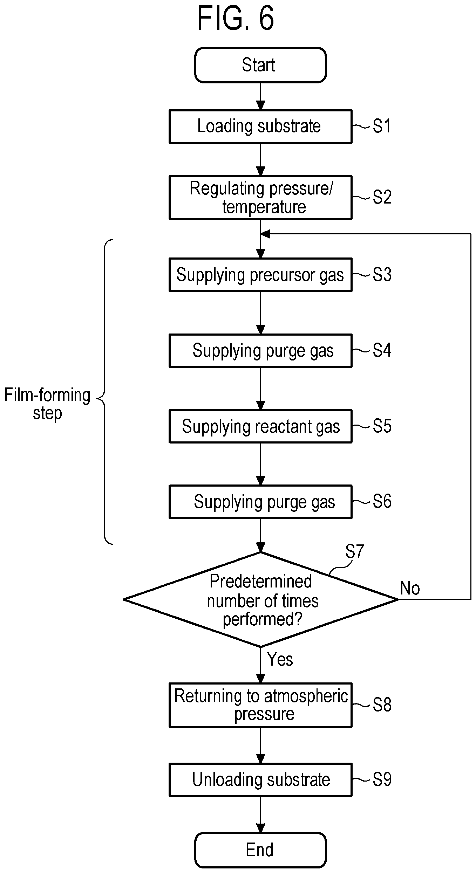

Next, an example of an execution procedure of a substrate processing method (method of manufacturing a semiconductor device) according to the present embodiments is described with reference to the flowchart of FIG. 6. Herein, a cycle processing in which a source gas (precursor gas) and a reactant gas are alternately supplied into the process chamber 2 for processing is described as an example of a semiconductor device manufacturing process. The present embodiments describes an example of forming a film on a substrate.

In the processing of the present embodiments, a film is formed on the substrate 31 by performing a cycle, including the following four steps performed non-simultaneously, a predetermined number of times (one or more times) to the substrate 31 within the process chamber 2:
·Step of supplying a precursor gas to the substrate 31 in the process chamber 2 (film-forming step 1: step S3 of FIG. 6);
·Purge Step of removing the precursor gas (residual gas) from the process chamber 2 (film-forming step 2: step S4 of FIG. 6);
·Step of supplying a nitrogen-containing gas to the substrate 31 in the process chamber 2 (film-forming step 3: step S5 of FIG. 6); and
·Purge Step of removing the nitrogen-containing gas (residual gas) from the process chamber 2 (film-forming step 4: step S6 of FIG. 6)

First, the boat 32 is charged with the substrate 31, and is then loaded into the process chamber 2 (step S1). At this time, after loading the boat 32 into the process chamber 2, a pressure and temperature of the process chamber 2 are regulated (step S2). Next, the four film-forming steps 1 to 4 are executed sequentially. Each step is described in detail below.

### (Film-Forming Step 1)

In film-forming step 1 (step S3), first, the precursor gas is adsorbed on a surface of the substrate 31. Specifically, in the first gas supply line, the valves AV3 and 97 are opened to supply the precursor gas generated in the precursor container 91 to the process chamber 2 by the MFC 100.

### (Film-Forming Step 2)

In film-forming step 2 (step S4), the valve AV3, the valve 97 of the first gas supply pipe 47, and the valve 55 of the first carrier gas supply pipe 53 are closed to stop the supply of the precursor gas and carrier gas. On the other hand, the valve 67 of the gas exhaust pipe 66 remains open, allowing the reaction tube 1 to be exhausted to 20 Pa or less by the vacuum pump 68 to remove the residual precursor gas from the process chamber 2. At this time, if an inert gas, such as N₂ gas used as the carrier gas, is supplied into the process chamber 2, the effect of removing the residual precursor gas is further enhanced.

### (Film-Forming Step 3)

In film-forming step 3 (step S5), the nitrogen-containing gas and carrier gas are flowed. First, both the valve 59 installed at the second gas supply pipe 48 and the valve 63 installed at the second carrier gas supply pipe 61 are opened, so that the nitrogen-containing gas, with a flow rate regulated by the MFC 58, from the second gas supply pipe 48 and the carrier gas, with a flow rate regulated by the MFC 62, from the second carrier gas supply pipe 61 are mixed. The mixed gas is then supplied into the process chamber 2 through the second gas supply holes 65 of the second nozzle 64, while simultaneously being exhausted through the gas exhaust pipe 66. By supplying the nitrogen-containing gas, a nitride film is formed on the substrate 31 through a reaction between the nitrogen-containing gas and a lower layer film of the substrate 31.

### (Film-Forming Step 4)

In film-forming step 4, after the film is formed, the valves 59 and 63 are closed, and the process chamber 2 is vacuum-exhausted by the vacuum pump 68 to remove any nitrogen-containing gas that is remaining after contributing to film formation. At this time, if the inert gas, such as N₂ gas used as the carrier gas, is supplied into the process chamber 2, the effect of removing the residual nitrogen-containing gas from the process chamber 2 is further enhanced.

Then, by performing a cycle, including the above-described film-forming steps 1 to 4, a predetermined number of times in step S7 of FIG. 6, it is possible to form a film with a predetermined film thickness on the substrate 31. In the present embodiments, film-forming steps 1 to 4 are repeated multiple times.

After the above-described film formation is completed, the pressure of the process chamber 2 is returned to normal pressure (atmospheric pressure) in step S8 of FIG. 6. Specifically, the inert gas such as nitrogen (N₂) gas, etc. is supplied into the process chamber 2 and is then exhausted. Thus, the process chamber 2 is purged with the inert gas, and any residual gases and others are removed from the process chamber 2 (inert gas purge). Thereafter, the atmosphere of the process chamber 2 is replaced with the inert gas (inert gas replacement), and the pressure of the process chamber 2 is returned to normal pressure (atmospheric pressure). Then, in step S9 of FIG. 6, the substrate 31 is unloaded from the process chamber 2, completing the substrate processing according to the present embodiments.

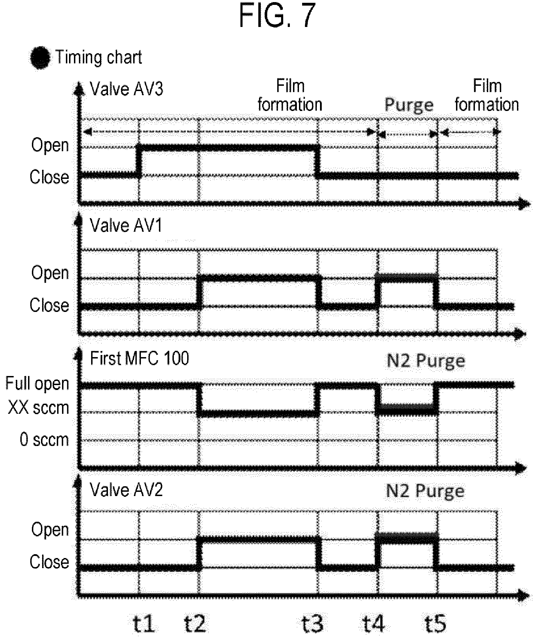

Operations of the MFC 100 and valves AV1 to AV3 are described with reference to the timing chart of FIG. 7. This timing chart exemplarily represents the operations of the MFC 100 and valves AV1 to AV3 during the film-forming and purge steps. The MFC 100 and valves AV1 and AV2 are configured to execute the above-described control mode (first mode) and full open mode (second mode).

The MFC 100 is set to the full open mode (second mode) in an initial state (before time t1 in FIG. 7). In the full open mode (second mode), no control voltage is applied to the MFC 100 and the valve 102 is fully opened. However, since both the valves AV1 and AV2 before and after the MFC 100 are in the closed state (CLOSE), no gas flows through a gas supply system including the MFC 100. At this time, a step of transferring the substrate 31, which corresponds to step S1 or step S9 in the substrate-processing process illustrated in FIG. 6, is being executed.

At time 11, the valve AV3 is opened to allow for an inflow of the precursor gas from the precursor container 91, but the MFC 100 still remains in the full open mode (where the MFC 100 is fully opened, but the valves AV1 and AV2 are closed). Thus, the primary side pressure of the MFC 100 increases, reaching a pressure suitable for the supply of the precursor gas.

This corresponds to step S2, i.e., a film-forming preparation step in the substrate-processing process illustrated in FIG. 6. In addition, this may be included in step S3 (the above-described film-forming step 1) assuming that the valve 97 is in the closed state. At this time, film-forming step 1 includes two steps, i.e., increasing the pressure to a level suitable for the supply of the precursor gas (step A) and opening the valves AV1, AV2 and 97 to supply the precursor gas (step B). In addition, the MFC 100 is in the full open mode in step A, but is in the control mode in step B.

As illustrated in FIG. 7, at time t2, the MFC 100 is switched from the full open mode to the control mode, so that the valve 102 thereof begins to operate to initiate the flow rate control of the fluid. Meanwhile, the valves AV1 and AV2 are switched to an open state at time t2. Thus, the precursor gas for the film formation is supplied into the process chamber 2 via the MFC 100. Appropriately regulating the valve 102 of the MFC 100 ensures that the precursor gas is supplied into the process chamber 2 under a suitable pressure. In addition, in the film-forming steps (steps S3 to S6) illustrated in FIG. 6, switching between the control mode (first mode) and the full open mode (second mode) may be repeated multiple times as needed, depending on a determined result in step S7. The controller 41 may execute the film-forming steps (steps S3 to S6) while appropriately switching the operation mode of the MFC 100 between the control mode (first mode) and the full open mode (second mode). Even during the execution of the film-forming steps (steps S3 to S6), the flow rate of the precursor gas may be appropriately regulated, and there may be a situation where the supply of the precursor gas may be stopped. In that case, if it is possible to appropriately set the MFC 100 to the full open mode (first mode), the load on the piezo actuator 101 of the MFC 100 may be reduced, thereby extending the lifespan of the MFC 100.

Once film formation is completed (at time t3 in FIG. 7), it returns to the initial state. Specifically, the valve AV3 is switched to a closed state, and the MFC 100 is also switched to the full open mode (where the MFC 100 is fully opened, but the valves AV1 and AV2 are closed). This corresponds to step S8 in the substrate-processing process illustrated in FIG. 6 in which the pressure of the process chamber 2 is returned to normal pressure (atmospheric pressure). Specifically, in step S8, the valve 97 is closed, but the valve 55 is opened to supply the inert gas, with a flow rate controlled by the MFC 54, from the carrier gas supplier 72 to the process chamber 2. In addition, a purge step as described later may be performed in step S8. After that, the purge step begins at time t4. In the purge step, the valves AV3, AV4 and 97 are closed to stop the supply of the precursor gas. The MFC 100 is switched to the control mode (first mode), and the valves AV1 and AV2 are opened. The valve AV5 is also opened, allowing the nitrogen gas supplied from the purge gas supply pipe 49 to flow into the MFC 100 through the bypass pipe after being heated by the heat exchanger HEx, thus performing the purge. The purge gas which passed through the MFC 100 is exhausted from a vent line (not illustrated). Thus, once the purge step of performing the pipe purge (nitrogen replacement) of a precursor gas supply system is completed at time t5, the supply of the purge gas from the purge gas supply pipe 49 is stopped, the valve AV5 is closed, and the MFC 100 and valves AV1 and AV2 are set back to the full open mode (initial state). At this time, since the pipe between the valve AV1 and the valve AV2 is filled with the purge gas (nitrogen), there is no problem even if the valve 102 is fully opened. Further, by executing the purge step, gas leakage from the MFC 100 may be minimized, and the reverse diffusion of a gas may be prevented. Furthermore, reducing the voltage load applied to the valve 102 may extend a replacement period for the MFC 100.

In addition, in the example of FIG. 7, when the valve AV3 of the precursor container 91 is opened to increase the primary side pressure of the MFC 100 (at time 11), or when the supply of the precursor gas from the precursor container 91 is stopped (at time t3), the valves AV1 and AV2 before and after the MFC 100 are both closed, and the MFC 100 is set to the full open mode (second mode). However, the present disclosure is not limited to this example. For example, it is also possible to close one of the valves AV1 and AV2, while the other remains open, and to set the MFC 100 to the control mode.

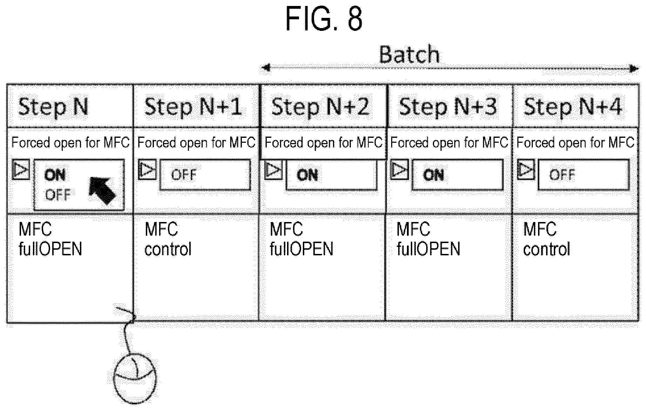

In addition, it is also possible to allow the user of the substrate processing apparatus to arbitrarily set whether to use the control mode (first mode) or the full open mode (second mode) for the MFC 100 in the multiple steps that constitute the substrate-processing process. For example, a setting screen as illustrated in FIG. 8 may be displayed on a display of the substrate processing apparatus, allowing the user to specify whether or not to execute the full open mode (second mode), which forces the MFC 100 to remain fully opened, for each of the multiple steps. In the example of FIG. 8, Steps N to N+4 may be set to, for example, an idling step as a waiting step of waiting for the loading of the substrate 31, a substrate loading step of loading the substrate 31 into the process chamber 2 (charging), a preparation step of preparing for a next step (standby), a film-forming step (deposition), a discharge step of unloading the substrate 31 from the process chamber 2 (discharging), a cooling step of cooling the substrate 31 whose processing is completed (cooling), and others. In addition, they may also be set to an alarm recipe step of issuing an alarm, a boat load step of loading the boat 32 (loading), and a boat unload step of unloading the boat 32 (unloading), and others. The operation mode of the MFC 100 suitable for various steps of the substrate processing may be set according to the user's operation. For example, the MFC 100 may be set to the full open mode (second mode) in the unload step of the boat 32. In addition, for multiple steps that are executed a number of times as part of a batch processing, the screen displays "BATCH" as illustrated in FIG. 8.

As illustrated in FIG. 8, the setting screen allows the user to toggle the full open mode (second mode) on or off for each step using an input device (such as a mouse). In the setting screen of FIG. 8, for example, an initial value for both the control mode (first mode) and the full open mode (second mode) in each step may be set by default as the full open mode (second mode). However, it is also possible to set the control mode (first mode) as a default value for the film-forming steps. In other words, it is desirable that the MFC 100 is configured to be set to the full open mode (second mode) by default for each step except for the film-forming steps. By setting the full open mode by default for steps other than the film-forming steps, the load on the piezo actuator of the MFC 100 may be minimized.

Once the control mode (first mode) or the full open mode (second mode) is set via such a setting screen, the controller 41 controls the MFC 100 and valves AV1 and AV2 based on that setting information.

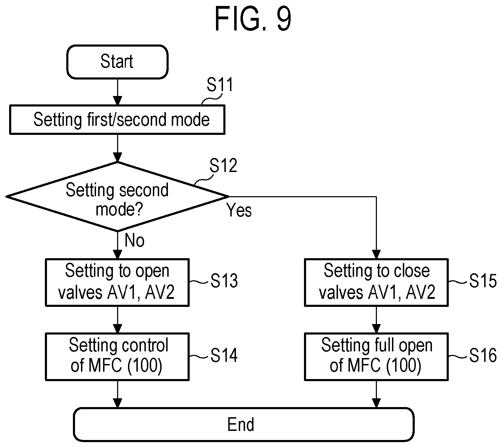

FIG. 9 is a flowchart illustrating an operation after setting the control mode (first mode) or the full open mode (second mode) for each step via the setting screen as illustrated in FIG. 8. In response to the control mode (first mode) or the full open mode (second mode) being set in step S 11, it is determined in step S12 whether the set mode is the control mode (first mode) or the full open mode (second mode). If the set mode is the control mode (first mode), the controller 41 issues a command to the MFC 100 to set the valves AV1 and AV2 to the valve open state (step S13), and sets the MFC 100 to a state where the valve 102 is appropriately controlled (step S14). On the other hand, if the set mode is the full open mode (second mode), the controller 41 issues a command to the MFC 100 to set the valves AV1 and AV2 to the valve closed state (step S15), and sets the MFC 100 to the full open state where the valve 102 is not controlled (step S16). The controller 41 may also be configured to determine the open/closed state of the valves AV1 and AV2, and when both are closed, to determine that the MFC 100 is in the full open mode (second mode) and issue a command to set the full open mode. Further, the controller 41 may be configured to issue a command to close one of the opened valves AV1 and AV2 when it is determined that the set mode is the full open mode (second mode) but either the valve AV1 or AV2 is open.

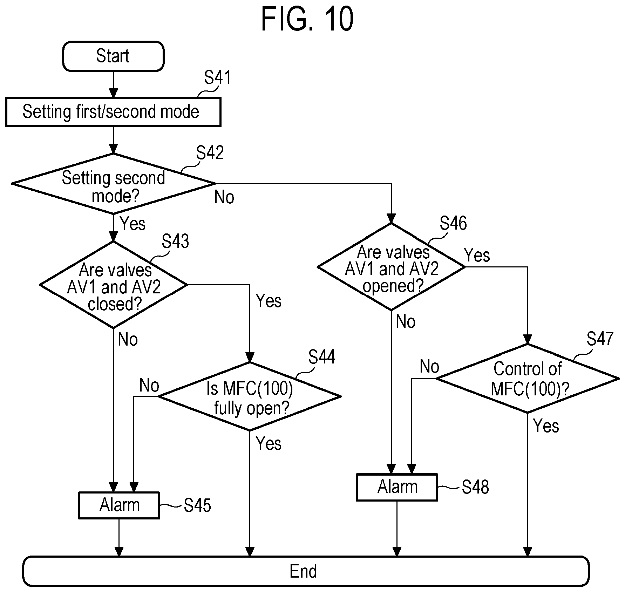

FIG. 10 is another flowchart illustrating a different operation example after setting the control mode (first mode) or the full open mode (second mode) for each step via the setting screen as illustrated in FIG. 8. In this operation example, if there is a mismatch between the operation of the MFC 100 and the operation of the valves AV1 and AV2 in the set operation mode, an alarm is issued to notify the user, etc. of this mismatch. In response to the control mode (first mode) or the full open mode (second mode) being set via the setting screen as illustrated in FIG. 8 (step S41), it is determined in step S42 whether the control mode (first mode) or the second mode is set.

If it is determined that the full open mode (second mode) is set ("YES"), the controller 41 determines whether the valves AV1 and AV2 are in the closed state (step S43). When the valves AV1 and AV2 are in the closed state ("YES"), the controller 41 then determines whether or not the MFC 100 is in the full open state (step S44). When the MFC 100 is determined to be in the full open state ("YES"), this matches the full open mode (second mode), and thus it is determined that normal settings are fulfilled, and no alarm is issued.

On the other hand, when it is determined that the MFC 100 is not in the full open state ("NO" in step S44), it is recognized that the MFC 100 is operating abnormally, and an alarm is issued to notify the user of the abnormal operation (step S45).

When it is determined in step S43 that either the valve AV1 or the AV2 is in the valve open state ("NO"), this does not match the full open mode (second mode), and as such an alarm is issued to notify the user of this mismatch (step S45).

When it is determined in step S42 that the control mode (first mode) is set ("NO"), the controller 41 determines whether or not the valves AV1 and AV2 are in the valve open state (step S46). When the valves AV1 and AV2 are in the valve open state ("YES"), it is then determined whether the MFC 100 is set to the control state (where the valve 102 is controlled) (step S47).

When it is determined that the MFC 100 is not in the control state ("NO"), it is recognized that the MFC 100 is operating abnormally, and thus an alarm is issued to notify the user of the abnormal operation (step S48). On the other hand, when the MFC 100 is determined to be in the control state ("YES"), this matches the control mode (first mode), and thus it is determined that normal settings are fulfilled, and no alarm is issued.

On the other hand, if it is determined that either the valve AV1 or the AV2 is not in the valve open state, this does not match the control mode (first mode), and thus an alarm is issued to notify the user of this mismatch (step S48). As described above, according to the operation example of FIG. 10, an alarm is issued if the state of the MFC 100 and valves AV1 and AV2 corresponding to the set first/second mode is not obtained, allowing the user to take appropriate actions such as repair or inspection in response to the alarm.

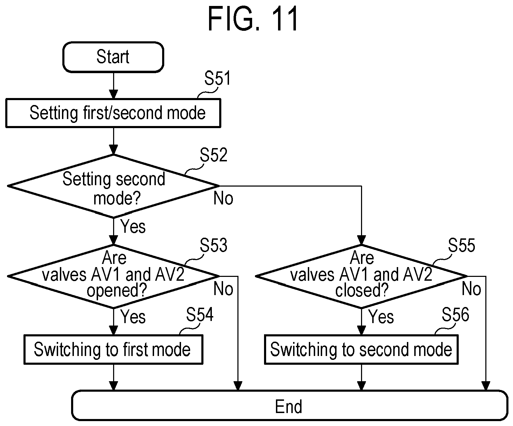

FIG. 11 is still another flowchart illustrating a different operation example after setting the control mode (first mode) or the full open mode (second mode) for each step via the setting screen as illustrated in FIG. 8. In this operation example, in response to a change in the open or closed state of the valves AV1 and AV2 occurred after the control mode (first mode) or the full open mode (second mode) is set, a corresponding mode switching is performed.

In the setting screen as illustrated in FIG. 8, the control mode (first mode) or the full open mode (second mode) is set (step S51), and the set mode is then determined (step S52). The MFC 100 and valves AV1 and AV2 are set according to the set mode, and begin to operate.

After that, it is determined whether the valve AV1 or AV2 is switched between the open and closed states due to the user's manual operation, malfunction, or other reasons (steps S53 and S55). If the state of the valve AV1 or AV2 is switched, the controller 41 responds to the switching of the valve AV1 or AV2 between the open and closed states based on the set operation mode of the MFC 100 (steps S54 and S56).

### (Other Embodiments)

Although the embodiments of the present disclosure are specifically described above, the present disclosure is not limited to the above-described embodiments, and various modifications may be made without departing from the gist of the present disclosure.

Further, for example, the above-described embodiments described a configuration in which, as the film formation performed by the substrate processing apparatus, a solid precursor is used in the precursor container, where the solid precursor is sublimated through heating to generate a precursor gas, but the present disclosure is not limited to this. Further, the above embodiments described, by way of example, a case where a nitrogen-containing gas is used as the reactant (reactant gas) and is alternately supplied with the precursor gas to form a nitride film on the substrate 31, but the present disclosure is not limited to this.

Herein, the solid precursor may be a solid precursor chemical, particularly, an inorganic solid precursor metal or a semiconductor precursor. For example, HfCl₄, ZrCl₄, AlCl₃, MoO₂Cl₂, MoCls SiI₄, etc. may be adopted as the solid precursor.

Further, the above-described embodiments described a configuration in which a precursor, which is supplied in a liquid state, is heated and vaporized to generate a precursor gas. Such a precursor gas may be, for example, a chlorosilane-based gas such as monochlorosilane (SiHsCl) gas, dichlorosilane (SiH₂Cl₂) gas, trichlorosilane (SiHCl₃) gas, tetrachlorosilane (SiCl₄) gas, hexachlorodisilane (Si₂Cl₆) gas, octachlorotrisilane (Si₃Cl₈) gas, etc. Further, the precursor gas may be, for example, a fluorosilane-based gas such as tetrafluorosilane (SiF₄) gas, difluorosilane (SiH₂F₂) gas, etc., a bromosilane-based gas such as tetrabromosilane (SiBr4) gas. dibromosilane (SiH₂Br₂) gas, etc., or an iodosilane-based gas such as tetraiodosilane (SiI₄) gas, diiodosilane (SiH₂I₂) gas, etc. Further, the precursor gas may be, for example, an aminosilane-based gas such as tetrakis(dimethylamino)silane (Si[N(CH₃)₂]₄) gas, tris(dimethylamino)silane (Si[N(CH₃) ₂]₃H) gas, bis(diethylamino)silane (Si[N(C₂H₅) ₂] ₂H₂) gas, bis(tert-butylamino)silane (SiH₂[NH(C₄H₉)] ₂), etc. Further, the precursor gas may be, for example, an organic silane precursor gas such as tetraethoxysilane (Si(OC₂H₅)₄) gas, etc. One or more of these gases may be used as the precursor gas. In other words, the precursor gas may also include a precursor that is stored in a liquid state by pressurization or cooling.

As the nitrogen-containing gas, for example, one or more of a nitrous oxide (N₂O) gas, nitric oxide (NO) gas, nitrogen dioxide (NO)₂) gas, ammonia (NH₃) gas, and others may be used.

Further, the reactant is not limited to the nitrogen-containing gas, and other types of thin films may be formed by using gases that react with a source to perform film processing. Furthermore, the film formation may be performed by using three or more types of process gases.

Further, an example in which a N₂ gas is used as an inert gas is described, but the present disclosure is not limited to this. For example, noble gases such as Ar gas, He gas, Ne gas, and Xe gas may also be used. However, in this case, a noble gas source is needed to be prepared. Further, this noble gas source needs to be connected to the first gas supply pipe 47 for introduction of the noble gas.

Further, for example, the above-described embodiments exemplified the film formation for the semiconductor devices as the processing performed by the substrate processing apparatus, but the present disclosure is not limited to this. The technique of the present disclosure may be applied to any types of processing performed by exposing a processing target with a high aspect ratio pattern (where the depth is greater than the width) to a vaporized gas. In other words, the present disclosure may be applied to formations of an oxide film, a nitride film, or a metal-containing film. Further, the specific content of substrate processing is not limited, and in addition to the film formation, the present disclosure may be suitably applied to other substrate processing such as annealing, oxidation, nitridation, diffusion, lithography, and others.

Furthermore, the present disclosure may be suitably applied to other substrate processing apparatuses, such as an annealing processing apparatus, oxidation processing apparatus, nitridation processing apparatus, exposure apparatus, coating apparatus, drying apparatus, heating apparatus, plasma-based processing apparatus, and others. Further, the present disclosure may also be applicable in cases where these apparatuses are used in combination.

Further, the present embodiments described a semiconductor manufacturing process, but the present disclosure is not limited to this. For example, the present disclosure may be applied to substrate processing in the manufacture of liquid crystal devices, the manufacture of solar cells, the manufacture of light-emitting devices, the processing of glass substrates, the processing of ceramic substrates, the processing of conductive substrates, etc.

Further, part of the configuration of one embodiment may be replaced with that of another embodiment, and it is also possible to add the configuration of one embodiment to that of another embodiment. Further, it is also possible to add, delete, or replace certain configurations of the embodiments with other configurations.

According to the present disclosure in some embodiments, it is possible to provide a technique capable of extending the lifespan of a flow-rate controller.

While certain embodiments are described, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A control system comprising:
a flow-rate controller (100) including a regulator (103) configured to be capable of regulating a flow rate of a gas; and
a controller (41) configured to be capable of switching between a first mode of the flow-rate controller (100) in which the flow rate of the gas is regulated to a predetermined flow rate through an operation of the regulator (103), and a second mode of the flow-rate controller (100) in which the regulator (103) is set to be in a full open state.

2. The control system of Claim 1, further comprising:
a first on-off valve (AV1) installed at an input-side pipe of the flow-rate controller (100); and
a second on-off valve (AV2) installed at an output-side pipe of the flow-rate controller (100),
wherein the controller (41) is configured to be capable of allowing the first on-off valve (AV1) and the second on-off valve (AV2) to be in a closed state when the flow-rate controller (100) is in the second mode.

3. The control system of Claim 2, wherein the first on-off valve (AV1) and the second on-off valve (AV2) are configured to perform a same operation.

4. The control system of Claim 1, wherein the flow-rate controller (100) is installed at an output side of a precursor container (91) accommodating a solid precursor or a liquid precursor.

5. The control system of Claim 2, wherein the first on-off valve (AV1) and the second on-off valve (AV2) are disposed to sandwich the flow-rate controller (100).

6. The control system of Claim 1, wherein the second mode is a mode in which flow rate control is not performed by the flow-rate controller (100).

7. The control system of Claim 1, wherein the regulator (103) is in an operation state in the first mode, and is in a non-operation state in the second mode.

8. The control system of Claim 1, wherein, when the regulator (103) is not in the full open state while the flow-rate controller (100) is set to the second mode, the controller (41) is configured to notify that the regulator (103) is not in the full open state.

9. The control system of Claim 2, wherein the first on-off valve (AV1) is installed at an upstream of the flow-rate controller (100) and the second on-off valve (AV2) is installed at a downstream of the flow-rate controller (100), and
wherein, when the flow-rate controller (100) is set to be in the second mode, the controller is configured to issue a command to set the flow-rate controller (100) to the second mode when the first on-off valve (AV1) and the second on-off valve (AV2) are in the closed state.

10. The control system of Claim 9, wherein, when either of the first on-off valve (AV1) or the second on-off valve (AV2) is in an open state, the controller (41) is configured to issue a command to close either the first on-off valve (AV1) or the second on-off valve (AV2), which is in the open state.

11. The control system of Claim 1, further comprising a setting screen configured to set a timing for issuing a command,
wherein the controller (41) switches modes of the flow-rate controller (100) according to a content set on the setting screen.

12. The control system of Claim 11, wherein a settable step on the setting screen is at least one selected from the group of an idling step as a waiting step of waiting for loading of a substrate (31), a substrate charging step of loading the substrate (31) into a process chamber, a preparation step of preparing for a next step, a film-forming step of forming a film on the substrate (31), a discharging step of unloading the substrate (31) from the process chamber, and a cooling step of cooling the substrate (31) whose processing is completed.

13. The control system of Claim 12, wherein the flow-rate controller (100) is configured to be capable of being set to the second mode in each step of the settable step except for the film-forming step.

14. A processing apparatus comprising:
a flow-rate controller (100) including a regulator (103) configured to be capable of regulating a flow rate of a gas; and
a controller (41) configured to be capable of switching between a first mode of the flow-rate controller (100) in which the flow rate of the gas is regulated to a predetermined flow rate through an operation of the regulator (103), and a second mode of the flow-rate controller (100) in which the regulator (103) is set to be in a full open state.

15. A method of manufacturing a semiconductor device, the method comprising supplying a gas to a substrate (31) by a control system including:
a flow-rate controller (100) including a regulator (103) configured to be capable of regulating a flow rate of the gas; and
a controller (41) configured to be capable of switching between a first mode of the flow-rate controller (100) in which the flow rate of the gas is regulated to a predetermined flow rate through an operation of the regulating, and a second mode of the flow-rate controller (100) in which the regulator (103) is set to be in a full open state.
